# EUROPÄISCHE PATENTSCHRIFT

(11) **EP 2 944 975 B1**
(45) Veröffentlichungstag und Bekanntmachung des Hinweises auf die Patenterteilung: **04.04.2018**
(21) Anmeldenummer: 15167527.9
(22) Anmeldetag: 13.05.2015
(51) Int. Cl.: H03M 3/00, H03M 1/06

(54) **VORRICHTUNG ZUR MESSUNG EINER SICH VERÄNDERNDEN PHYSIKALISCHEN GRÖSSE, WIE Z.B. DRUCK**
DEVICE FOR MEASURING A CHANGING PHYSICAL PARAMETER, SUCH AS PRESSURE
DISPOSITIF DE MESURE D'UNE TAILLE PHYSIQUE SE MODIFIANT, PAR EXEMPLE LA PRESSION

(30) Priorität: 14.05.2014 EP 14168339
(43) Veröffentlichungstag der Anmeldung: 18.11.2015
(73) Patentinhaber: Elmos Semiconductor Aktiengesellschaft, 44227 Dortmund (DE)
(72) Erfinder: Dr. Spiegel, Egbert, 44227 Dortmund (DE); Friemann, Uwe, 44227 Dortmund (DE); Dr. Budde, Wolfram, 44227 Dortmund (DE)
(74) Vertreter: dompatent von Kreisler Selting Werner - Partnerschaft von Patent- und Rechtsanwälten mbB

(56) Entgegenhaltungen:
- DE-A1- 19 757 296
- DE-A1-102009 029 051
- US-A1- 2007 216 562
- US-A1- 2009 079 607
- US-A1- 2010 289 682
- US-A1- 2011 063 146
- US-B1- 6 891 430

## Beschreibung

Die Erfindung betrifft eine Vorrichtung zur Messung einer sich verändernden physikalischen Größe, bei der es sich beispielsweise um den Druck handelt.

Messvorrichtungen zur Erfassung physikalischer Größen sind bekannt. Dabei werden entsprechende Sensoren eingesetzt, die ein analoges Messsignal ausgeben, die zu messende physikalische Größe also in ein Messsignal wandeln. Diese Messsignale sind mitunter sehr klein und ggf. auch stark verrauscht. Auch können die Messsignale Offset-behaftet sein. Die Messsignale werden im Regelfall in einer Signalverarbeitungseinheit verarbeitet, wobei am Eingang einer derartigen Signalverarbeitungseinheit ein Messverstärker angeordnet ist, der sowohl Offset-behaftet als auch verrauscht sein kann.

Zur Rauschunterdrückung eines zu verstärkenden Signals ist es bekannt, das Signal im Frequenzbereich hochzumischen, um es erst dann zu verstärken und anschließend wieder herunterzumischen. Dieses Konzept kann auch in Kombination mit einer Analog-Digital-Wandlung des Signals angewendet werden (siehe z.B. US-A-2007/0216562 und US-A-2009/0079607). Während bei der Schaltung nach US-A-2009/0079607 das an sich bekannte Chopper-Konzept im Signalpfad innerhalb des A-D-Wandlers angewendet wird, kann gemäß Fig. 3 in US-A-2007/0216562 nach der Verstärkung des hochgemischten Signals eine Signaldemodulation, eine Filterung oder eine andere nicht weiter spezifizierte Signalverarbeitung erfolgen. In der zuletzt genannten Schrift ist ein Heruntermischen des verstärkten und A-D-gewandelten Signals nicht beschrieben, so dass ferner dieser Schrift konsequenterweise auch nicht entnommen werden kann, welches Mischerkonzept zum Heruntermischen eingesetzt werden kann. Der Hinweis auf eine Signaldemodulation jedenfalls besagt insoweit nichts.
Aufgabe der Erfindung ist es, eine Vorrichtung zur Messung einer sich verändernden physikalischen Größe zu schaffen, bei der mit möglichst geringem Aufwand eine verbesserte Rauschunterdrückung erzielt werden kann.

Zur Lösung dieser Aufgabe wird mit der Erfindung eine Vorrichtung zur Messung einer sich verändernden physikalischen Größe, wie z.B. Druck, vorgeschlagen, wobei die Vorrichtung versehen ist mit den Merkmalen des Anspruchs 1. Einzelne Ausgestaltungen der Erfindung sind Gegenstand der jeweiligen Unteransprüche.

Der Erfindung liegt die Kenntnis zugrunde, dass mit sogenannten Chopperkonzepten grundsätzlich eine verbesserte Rauschunterdrückung erzielt werden kann. Problematisch allerdings ist bei derartigen Chopperkonzepten, dass der Aufwand der Frequenzmischer zum Hoch- und Heruntermischen des zu verarbeitenden Messsignals schaltungstechnisch recht aufwändig ist. Idealerweise werden als Frequenzmischer zum Hochmischen des Messsignals, also zum Verschieben der Frequenzen des Messsignals um eine Verschiebefrequenz f_{D} zu höheren Frequenzen hin, Sinusfrequenzmischer eingesetzt. Chopperkonzepte werden genutzt, um beispielsweise Verstärker-Offsets und niederfrequentes Verstärker-Rauschen (sogenanntes 1/f-Rauschen) einfacher unterdrücken zu können. Bei dem Sinusfrequenzmischer handelt es sich also um eine Analog-Schaltung, da es sich bei dem durch den Verstärker zu verstärkenden Signal um ein Analog-Signal (Messsignal des Sensors) handelt. Die Realisierung eines Analog-Sinusfrequenzmischers ist recht aufwändig, weshalb erfindungsgemäß ein Analog-Rechteckfrequenzmischer verwendet wird.

Nach der Verstärkung des derart hochgemischten Messsignals erfolgt erfindungsgemäß eine Analog-Digital-Wandlung des Analogsignals in ein Digitalsignal. In der Signalverarbeitungseinheit nach der Erfindung wird anschließend das Heruntermischen durch einen Sinusfrequenzmischer realisiert, der digital ausgeführt sein kann und damit wesentlich einfacher realisiert werden kann als ein Sinusfrequenzmischer für Analog-Signale.

Nach dem erfindungsgemäßen Konzept wird also der zur Rauschunterdrückungsverbesserung zu betreibende Hardware-Aufwand (nämlich für das Heruntermischen des verarbeiteten Messsignals) in den Digitalbereich der erfindungsgemäßen Vorrichtung "verschoben", indem der Analog-Digital-Wandler sich in dem "gechoppten" Teil des Signalpfads befindet und damit das digitale Signal herunter gemischt wird. Bei diesem Konzept wird erfindungsgemäß ausgenutzt, dass sich ein Sinusfrequenzmischer zum Heruntermischen, d.h. zum Verschieben der Frequenzen um die Verschiebefrequenz f_{D} zu niedrigeren Frequenzen hin, als Digital-Frequenzmischer recht einfach realisieren lässt, wohingegen als Frequenzmischer zum Heraufmischen der Frequenzen des analogen Messsignals um die Verschiebefrequenz f_{D} zu höheren Frequenzen hin als Analog-Rechteckfrequenzmischer ausgeführt wird.

Neben der einfacheren Hardware-Realisierung eines Digital-Sinusfrequenzmischers zum Zurückverschieben des gechoppten, d.h. hochgemischten Signals gegenüber einem Rechteckfrequenzmischer bietet gerade die Kombination aus Rechteckfrequenz-Aufwärtsmischer und Sinusfrequenz-Abwärtsmischer einen weiteren erfindungswesentlichen Vorteil. Der Rechteckmischer ist beim Hochmischen insoweit zweckmäßiger als ein Sinusmischer, als die Grundwelle des Rechtecks 4/π größer ist als beim Sinusmischer. Man kann dadurch einen Signal(energie)gewinn von ca. 27 % erzielen. Leider enthält unerwünschterweise das hochgemischte Signal auch Mischprodukte bei den ungeradzahligen Vielfachen der Grundfrequenz des Rechtecks. Die aber werden nun vorteilhafterweise nicht heruntergemischt, wenn, wie mit der Erfindung vorgeschlagen, zum Heruntermischen ein Sinusmischer verwendet wird. Beim Zurückmischen mit einem Rechteckmischer wird auch das hochfrequente Wandlerrauschen zurückgemischt. Dieses kann durch Filterung dann nicht mehr reduziert werden, da diese Anteile alle wieder bei f=0 liegen. Beim Sinusmischer wird lediglich der Anteil bei der Chopper-Frequenz fchop zurückgemischt. Grundsätzlich geht beim Zurückmischen durch einen Sinusmischer ein (kleiner) Teil der Signalenergie und zwar beim 3-Fachen, 5-Fachen, etc. der Chopper-Frequenz fchop verloren. Insgesamt aber ergibt sich eine Verbesserung des Signalrauschabstandes von ungefähr 5dB gegenüber einem Rechteckmischer. Somit liegt ein wesentlicher Aspekt der Erfindung in der Kombination der Verwendung eines Rechteckmischers zum Hochmischen des Analogsignals, der Verstärkung des hochgemischten Signals, der Analog-Digital-Wandlung des hochgemischten Signals und in dem Heruntermischen des Digital-Signals mittels eines Sinusmischers.

Ferner ist nach der Erfindung ein dem Digital-Sinusfrequenzmischer nachgeschaltetes, am Ausgang der Signalverarbeitungseinheit angeordnetes erstes Filter zur Unterdrückung von durch den Analog-Rechteckfrequenzmischer verursachten und durch den Digital-Sinusfrequenzmischer in der Frequenz nach unten verschobenen Signalstellen bei ungeradzahligen Oberwellen der Verschiebefrequenz f_{D} vorgesehen.

Eine weitere zweckmäßige Ausgestaltung der Erfindung kann durch ein weiteres, dem Digital-Sinusfrequenzmischer nachgeschaltetes, am Ausgang der Signalverarbeitungseinheit angeordnetes Bandpassfilter zur Bandbegrenzung des Ausgangssignals des Digital-Sinusfrequenzmischers oder des ersten Filters gekennzeichnet sein.

Zweckmäßig kann es ferner sein, wenn der Analog-Digital-Wandler als monoton arbeitender bzw. als im Wesentlichen monoton arbeitender Analog-Digital-Wandler ausgebildet ist.

Bei einer weiteren vorteilhaften Ausgestaltung der Erfindung kann vorgesehen sein, dass der Analog-Digital-Wandler als Delta-Sigma-Wandler ausgebildet ist, dass dem Delta-Sigma-Wandler ein Dezimationsfilter zum Filtern von Rauschen im Digitalsignal unter Entstehung einer Phasenverschiebung des gefilterten Digitalsignals an einem Ausgang des Dezimationsfilters nachgeschaltet ist und dass zwischen dem Delta-Sigma-Wandler und dem Dezimationsfilter ein digitaler Phasenschieber zur Kompensation der durch das Dezimationsfilter entstehenden Phasendrehung geschaltet ist.

Zweckmäßig kann es sein, wenn der Analog-Digital-Wandler als SAR-(Successive-Approximation-Register-)Wandler ausgebildet ist.

In weiterer zweckmäßiger Ausgestaltung der Erfindung ist es möglich, dass der Sensor eine Messbrückenschaltung aufweist. Dieser Sensor bzw. Messbrückenschaltung kann als Spannungsgeber, insbesondere Differenzspannungswandler, als Wheatstonesche Brücke ausgebildet sein, die vornehmlich ein piezoresistives Bauelement als z.B. Drucksensor aufweist. Grundsätzlich gilt, dass der Sensor aus einer physikalischen Messgröße eine Differenzspannung erzeugt, wie dies beispielsweise bei einem Thermoelement der Fall sein kann. Andere Sensorkonzepte sind ebenfalls denkbar.

In weiterer zweckmäßiger Ausgestaltung der Erfindung kann vorgesehen sein, dass der Sensor ein mit einem Sensor-Offset behaftetes Messsignal ausgibt und dass der Sensor-Offset mittels eines weiteren Analog-Rechteckfrequenzmischers um die Verschiebefrequenz f_{D} zu höheren Frequenzen hin verschiebbar und dem Signalpfad zwischen dem Sensor und dem Analog-Digital-Wandler vor, hinter oder im Verstärker unter Bildung einer Differenz mit dem betreffenden Signal vor, hinter oder im Verstärker zuführbar ist. Ferner kann mit Vorteil vorgesehen sein, dass der Verstärker eine erste Verstärkerstufe zur Vorverstärkung des analogen Messsignals und eine zweite Verstärkerstufe aufweist, wobei das nach der zweiten Verstärkerstufe vorliegende verstärkte Analogsignal dem Analog-Digital-Wandler zuführbar ist, und dass der um die Verschiebefrequenz f_{D} verschobene Sensor-Offset der zweiten Verstärkerstufe unter Bildung einer Differenz mit dem Ausgangssignal der ersten Verstärkerstufe zuführbar ist.

Die Erfindung wird nachfolgend anhand zweier Ausführungsbeispiele sowie unter Bezugnahme auf die Zeichnung näher erläutert. Im Einzelnen zeigen dabei:
- Fig. 1: ein erstes Schaltungskonzept nach der Erfindung und
- Fig. 2: ein zweites Schaltungskonzept nach der Erfindung, wobei gestrichelt angedeutet ist, an welcher Stelle ein Offset behaftetes Sensorsignal in den Signalverarbeitungspfad vor, hinter oder im Messverstärker eingebracht wird.

Leistungsstarke Auto-Zero-Messverstärker, wie sie zum Verstärken analoger Messsignale von beispielsweise Drucksensoren oder Sensoren für andere physikalische Parameter eingesetzt werden, weisen Rauschleistungsdichten in Bereichen auf, die für eine Vielzahl von Anwendungen als unzureichend erscheinen. Damit ein Sensorsystem quasi "transparent" ist, sind rauschwerte vonnöten, die deutlich kleiner als die Rauschleistungsdichten von heute käuflich erhältlichen Messverstärkern sind. Untersuchungen haben ergeben, dass Chopperkonzepte grundsätzlich eine bessere Rauschunterdrückung bewirken können. Bei dem erfindungsgemäßen Konzept wird der Hardware-Aufwand zur Rauschunterdrückung in den Digitalbereich einer Vorrichtung zur Messung einer sich verändernden physikalischen Größe wie beispielsweise Druck, verschoben, indem der Analog-Digital-Wandler mit in den gechoppten Signalpfad geschaltet wird.

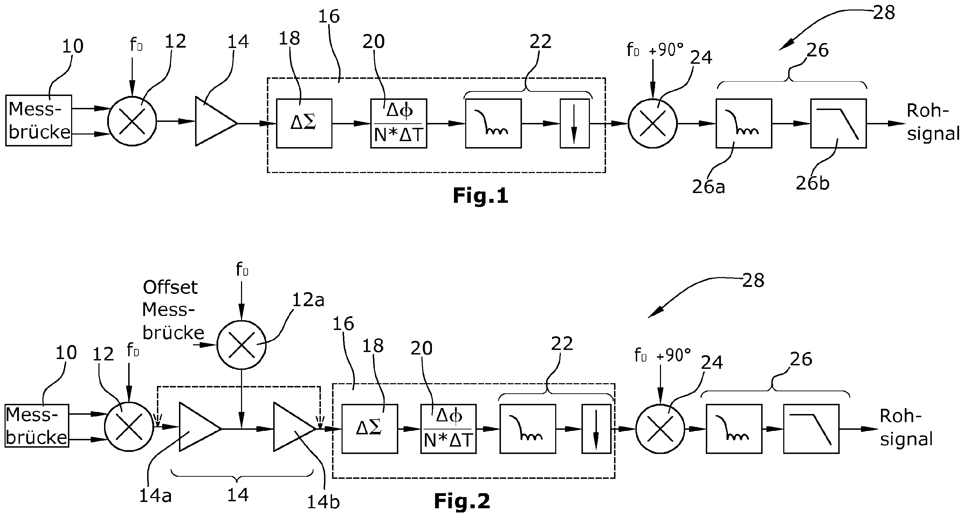

Fig. 1 zeigt ein erstes Ausführungsbeispiel eines derartigen Schaltungskonzepts. Das Signal einer Messbrücke bzw. eines Sensors 10 wird mit Hilfe eines Analog-Rechteckfrequenzmischers 12 (auch Umtaster genannt) um eine Verschiebefrequenz f_{D} zu höheren Frequenzen hin verschoben. Bei dem Messsignal des Sensors 10 handelt es sich um ein Wechselsignal, das in einem nachgeschalteten (Mess-)Verstärker 14 verstärkt wird. Von Vorteil hierbei ist, dass aufgrund des Chopperkonzepts bei diesem Verstärker 14 keine weiteren Maßnahmen zur Unterdrückung seines Offset vorgenommen werden müssen. Damit kann der Verstärker 14 schaltungstechnisch relativ einfach gehalten sein. Lediglich seine Bandbreite muss ausreichend groß sein, um die frequenzgemischten Messsignale fehlerfrei zu verstärken. Allerdings weist das in der Frequenz hochgemischte Signal nicht nur bei der Grundfrequenz (Verschiebefrequenz f_{D}) sondern auch bei den Frequenzen der durch den Analog-Rechteckfrequenzmischer 12 verursachten ungeradzahligen Oberwellen der Grundfrequenz (geradzahlige Oberwellen existieren nicht) Mischprodukte auf, die allerdings gemäß dem Erfindungskonzept später mit minimalem Aufwand unterdrückt bzw. herausgefiltert werden.

Dem Verstärker 14 nachgeschaltet ist ein Analog-Digital-Wandler 16, der in diesem Ausführungsbeispiel als Delta-Sigma-Wandler 18 mit nachgeschaltetem Digital-Phasenschieber 20 und mit einem Dezimationsfilter 22 ausgebildet ist. Das Dezimationsfilter 22 filtert das Rauschen des Delta-Sigma-Wandlers 18 und setzt das 1-Bit-Signal des Wandlers in ein Signal mit einer Breite von mehreren Bits um. Die durch diese Filterung entstehende Phasendrehung des Signals wird durch den dem Dezimationsfilter 22 vorgeschalteten Digital-Phasenschieber 20 auf einen Wert gebracht, so dass das gechoppte Signal in Phase zu einem zweiten Mischer ist. Dieser zweite Mischer ist als Digital-Sinusfrequenzmischer 24 ausgebildet. Dieser Digital-Sinusfrequenzmischer 24 verschiebt das Signal um die Verschiebefrequenz f_{D} zu niedrigeren Frequenzen hin, ohne dass die beim Hochmischen durch den Analog-Rechteckmischer verursachten Mischprodukte bei den ungeradzahligen Oberwellen der Rechteck-Grundfrequenz mit heruntergemischt werden. Die Ausbildung des Mischers als Rechteckmischer hätte dagegen den Nachteil, dass Rauschanteile bei ungeradzahligen Vielfachen der Mischerfrequenz ebenfalls wiederum heruntergemischt würden.

Ein weiteres Filter 26 mit den Komponenten 26a und 26b am Ausgang der Signalverarbeitungseinheit 28 aus Analog-Digital-Wandler 16, Analog-Rechteckfrequenzmischer 12 und Digital-Sinusfrequenzmischer 24 dient der Bandbegrenzung (Filterkomponente 26b) und der Unterdrückung (Filterkomponente 26a) der heruntergemischten Mischprodukte bei den ungeradzahligen Oberwellen der Grundfrequenz, die auf den Analog-Rechteckfrequenzmischer 12 zurückzuführen sind.

Fig. 2 zeigt ein alternatives Schaltungskonzept, bei dem die Möglichkeit gegeben wird, innerhalb des Signalverstärkungspfades einen Offset, der beispielsweise hervorgerufen ist durch die Offsetspannung der Messbrücke bzw. des Sensors 10, abzuziehen. Damit kann die Verstärkung deutlich erhöht werden. Dieses Konzept kann auch angewendet werden, wenn der Offset entsprechend zum Eingangssignal ebenfalls um die Verschiebefrequenz f_{D} heraufgemischt wird. In Fig. 2 ist der Verstärker 14 als zweistufiger Verstärker mit einer ersten und einer zweiten Verstärkerstufe 14a, 14b gezeigt. Das über einen Analog-Rechteckfrequenzmischer 12a hochgemischte Offset-Signal der Messbrücke bzw. des Sensors 10 kann vor, zwischen bzw. hinter den beiden Verstärkerstufen 14a, 14b in den Signalpfad eingespeist werden. Im Übrigen weist die Signalverarbeitungseinheit beim Schaltungskonzept gemäß Fig. 2 die gleichen Komponenten aus, wie es oben im Zusammenhang mit dem Schaltungskonzept nach Fig. 1 beschrieben und in Fig. 1 gezeigt ist, weshalb insoweit in Fig. 2 die gleichen Bezugszeichen verwendet worden sind, wie in Fig. 1.

### BEZUGSZEICHENLISTE

- 10: Sensor
- 12: Analog-Rechteckfrequenzmischer
- 12a: Analog-Rechteckfrequenzmischer
- 14: Verstärker
- 14a: Verstärkerstufe
- 14b: Verstärkerstufe
- 16: Analog-Digital-Wandler
- 18: Delta-Sigma-Wandler
- 20: Digital-Phasenschieber
- 22: Dezimationsfilter
- 24: Digital-Sinusfrequenzmischer
- 26: Filter
- 26a: Filterkomponente des Filters
- 26b: (Bandpass-)Filterkomponente des Filters
- 28: Signalverarbeitungseinheit

## Patentansprüche

1. Vorrichtung zur Messung einer sich verändernden physikalischen Größe, wie z.B. Druck, mit
- einem Sensor (10), der ein analoges Messsignal ausgibt, und
- einer Signalverarbeitungseinheit (28) mit einem das Messsignal des Sensors (10) empfangenden Eingang und einem Ausgang zur Ausgabe des verarbeiteten Messsignals,
- wobei die Signalverarbeitungseinheit (28) versehen ist mit
- einem an ihrem Eingang angeordneten Analog-Rechteckfrequenzmischer (12) zum Frequenzverschieben des Messsignals des Sensors (10) um eine Verschiebefrequenz f_{D} zu höheren Frequenzen hin,
- einem Verstärker (14) zum Verstärken des frequenzverschobenen Messsignals, wobei der Verstärker (14) einen Verstärker-Offset erzeugt und
- einem Analog-Digital-Wandler (16) zur Wandlung des verstärkten Analogsignals des Verstärkers (14) in ein Digitalsignal
**gekennzeichnet durch**
- einen am Ausgang der Signalverarbeitungseinheit (28) angeordneten Digital-Sinusfrequenzmischer (24) zum Verschieben des Ausgangssignals des Analog-Digital-Wandlers um die Verschiebefrequenz f_{D} zu niedrigeren Frequenzen hin und
- ein dem Digital-Sinusfrequenzmischer (24) nachgeschaltetes, am Ausgang der Signalverarbeitungseinheit (28) angeordnetes erstes Filter (26a) zur Unterdrückung von durch den Analog-Rechteckfrequenzmischer (12) verursachten und durch den Digital-Sinusfrequenzmischer (24) in der Frequenz nach unten verschobenen Signalanteilen bei ungeradzahligen Oberwellen der Verschiebefrequenz f_{D}.

2. Vorrichtung nach Anspruch 1, **gekennzeichnet durch** ein weiteres, dem Digital-Sinusfrequenzmischer (24) nachgeschaltetes, am Ausgang der Signalverarbeitungseinheit (28) angeordnetes Tiefpassfilter (26b) zur Bandbegrenzung des Ausgangssignals des Digital-Sinusfrequenzmischers (24) oder des ersten Filters.

3. Vorrichtung nach Anspruch 1 oder 2, **dadurch gekennzeichnet, dass** der Analog-Digital-Wandler (16) als monoton arbeitender bzw. als im Wesentlichen monoton arbeitender Analog-Digital-Wandler (16) ausgebildet ist.

4. Vorrichtung nach einem oder mehreren der Ansprüche 1 bis 3, **dadurch gekennzeichnet, dass** der Analog-Digital-Wandler (16) als Delta-Sigma-Wandler (18) ausgebildet ist, dass dem Delta-Sigma-Wandler (18) ein Dezimationsfilter (22) zum Filtern von Rauschen im Digitalsignal unter Entstehung einer Phasenverschiebung des gefilterten Digitalsignals an einem Ausgang des Dezimationsfilters (22) nachgeschaltet ist und dass zwischen dem Delta-Sigma-Wandler (18) und dem Dezimationsfilter (22) ein Digital-Phasenschieber (20) zur Kompensation der durch das Dezimationsfilter (22) entstehenden Phasendrehung geschaltet ist.

5. Vorrichtung nach einem oder mehreren der Ansprüche 1 bis 3, **dadurch gekennzeichnet, dass** der Analog-Digital-Wandler (16) als SAR-(Successive-Approximation-Register-)Wandler ausgebildet ist.

6. Vorrichtung nach einem oder mehreren der Ansprüche 1 bis 5, **dadurch gekennzeichnet, dass** der Sensor (10) eine Messbrückenschaltung aufweist.

7. Vorrichtung nach einem oder mehreren der Ansprüche 1 bis 5, **dadurch gekennzeichnet, dass** der Sensor (10) ein mit einem Sensor-Offset behaftetes Messsignal ausgibt und dass der Sensor-Offset mittels eines weiteren Analog-Rechteckfrequenzmischers (12a) um die Verschiebefrequenz f_{D} zu höheren Frequenzen hin verschiebbar und dem Signalpfad zwischen dem Sensor (10) und dem Analog-Digital-Wandler (16) vor, hinter oder im Verstärker (14) unter Bildung einer Differenz mit dem betreffenden Signal vor, hinter oder im Verstärker (14) zuführbar ist.

8. Vorrichtung nach Anspruch 7, **dadurch gekennzeichnet, dass** der Verstärker (14) eine erste Verstärkerstufe zur Vorverstärkung des analogen Messsignals und eine zweite Verstärkerstufe aufweist, wobei das nach der zweiten Verstärkerstufe vorliegende verstärkte Analogsignal dem Analog-Digital-Wandler (16) zuführbar ist, und dass der um die Verschiebefrequenz f_{D} verschobene Sensor-Offset der zweiten Verstärkerstufe unter Bildung einer Differenz mit dem Ausgangssignal der ersten Verstärkerstufe zuführbar ist.

## Claims

1. A device for measuring a varying physical quantity such as e.g. pressure, comprising
- a sensor (10) which outputs an analog measurement signal, and
- a signal processing unit (28) having an input receiving the measurement signal of the sensor (10) and an output for outputting the processed measuring signal,
- wherein the signal processing unit (28) is provided with
- an analog rectangular frequency mixer (12) arranged at its input, for frequency-shifting the measurement signal of the sensor (10) by a shift frequency f_{D} towards higher frequencies,
- an amplifier (14) for amplifying the frequency-shifted measuring signal, wherein the amplifier (14) generates an amplifier offset, and
- an analog-to-digital converter (16) for converting the amplified analog signal of the amplifier (14) into a digital signal,
**characterized by**
- a digital sine frequency mixer (24) arranged at the output of the signal processing unit (28) for shifting of the output signal of the analog-to-digital converter by the shift frequency f_{D} towards lower frequencies, and
- a first filter (26a) connected downstream of the digital sine frequency mixer (24) and arranged at the output of the signal processing unit (28), for suppressing, at odd harmonics of the frequency shift f_{D}, signal components caused by the analog rectangular frequency mixer (12) and shifted downward in their frequency by the digital sine frequency mixer (24).

2. The device according to claim 1, **characterized by** a further low-pass filter (26b) connected downstream of the digital sine frequency mixer (24) and arranged at the output of the signal processing unit (28), for band limitation of the output signal of the digital sine frequency mixer (24) or the first filter.

3. The device according to claim 1 or 2, **characterized in that** the analog-to-digital converter (16) is configured as a monotonically-operating or substantially monotonically-operating analog-digital converter (16).

4. Device according to any one or more of claims 1 to 3, **characterized in that** the analog-to-digital converter (16) is configured as a delta-sigma converter (18), that the delta-sigma converter (18) is connected, downstream of it, to a decimation filter (22) for filtering noise in the digital signal with generation of a phase shift of the filtered digital signal at an output of the decimation filter (22), and that, between the delta-sigma converter (18) and the decimation filter (22), a digital phase shifter (20) is connected for compensating the phase rotation caused by the decimation filter (22).

5. Device according to any one or more of claims 1 to 3, **characterized in that** the analog-to-digital converter (16) is designed as an SAR (successive approximation register) converter.

6. Device according to any one or more of claims 1 to 5, **characterized in that** the sensor (10) comprises a measuring bridge circuit.

7. Device according to any one or more of claims 1 to 5, **characterized in that** the sensor (10) outputs a measurement signal having a sensor offset and that the sensor offset can be shifted by the shift frequency f_{D} toward higher frequencies by means of a further analog-torectangular frequency mixer (12a), and can be supplied to the signal path between the sensor (10) and the analog-to-digital converter (16) before, behind or in the amplifier (14) with generation of a difference with the respective signal before, behind or in the amplifier (14).

8. Device according to claim 7, **characterized in that** the amplifier (14) comprises a first amplifier stage for preamplifying the analog measurement signal and a second amplifier stage, wherein the amplified analog signal present after the second amplifier stage can be supplied to the analog-to-digital converter (16), and that the sensor offset, shifted by the shift frequency f_{D}, of the second amplifier stage can be fed to the first amplifier stage with generation of a difference with the output signal.

## Revendications

1. Appareil de mesure d'une grandeur physique variable, comme par exemple la pression, doté
d'un capteur (10) délivrant un signal de mesure analogique, et
d'une unité de traitement du signal (28) dotée d'une entrée recevant le signal de mesure du capteur (10) et d'une sortie délivrant le signal de mesure traité,
dans lequel l'unité de traitement du signal (28) est prévue dotée
d'un mélangeur de fréquences analogique-carré (12) pour le décalage vers le haut de fréquences du signal de mesure du capteur (10) autour d'une fréquence de décalage f_{D},
d'un amplificateur (14) pour l'amplification du signal de mesure décalé en fréquence, dans lequel l'amplificateur (14) produit un décalage d'amplificateur et
d'un convertisseur numérique-analogique (16) pour la conversion du signal analogique amplifié de l'amplificateur (14) en un signal numérique
**caractérisé par**
un mélangeur de fréquences numérique-sinusoïdal (24) agencé à la sortie de l'unité de traitement du signal (28) pour le décalage vers le bas du signal de sortie du convertisseur numérique-analogique autour de la fréquence décalée f_{D} et
un premier filtre (26a) agencé à la sortie de l'unité de traitement du signal (28) en aval du mélangeur de fréquences numérique-sinusoïdal (24), pour la suppression des composantes du signal causées par le mélangeur de fréquences analogique-carré (12) et décalées en fréquence vers le bas par le mélangeur de fréquences numérique-sinusoïdal (24) lors des harmoniques impaires de la fréquence de décalage f_{D}.

2. Appareil selon la revendication 1, **caractérisé par** un filtre passe-bas (26b) supplémentaire agencé à la sortie de l'unité de traitement du signal (28) en aval du mélangeur de fréquences numérique-sinusoïdal (24) pour la limitation de bande du signal de sortie du mélangeur de fréquences numérique-sinusoïdal (24) ou du premier filtre.

3. Appareil selon la revendication 1 ou 2, **caractérisé en ce que** le convertisseur numérique-analogique (16) est conçu comme un convertisseur numérique-analogique (16) opérant de manière monotone ou essentiellement monotone.

4. Appareil selon au moins l'une des revendications 1 à 3, **caractérisé en ce que** le convertisseur numérique-analogique (16) est conçu comme convertisseur Delta-Sigma (18), et **en ce qu'**un filtre décimateur (22) pour le filtrage du bruit dans le signal numérique par production d'un décalage de phase dans le signal numérique filtré à une sortie du filtre décimateur (22) est situé en aval du convertisseur Delta-Sigma (18) et **en ce qu'**un déphaseur numérique (20) pour compenser la rotation de phase produite par le filtre décimateur (22) est commuté entre le convertisseur Delta-Sigma (18) et le filtre décimateur (22) .

5. Appareil selon au moins une des revendications 1 à 3, **caractérisé en ce que** le convertisseur numérique-analogique (16) est conçu comme convertisseur à approximations successives.

6. Appareil selon au moins une des revendications 1 à 5, **caractérisé en ce que** le capteur (10) comporte un circuit de pont de mesure.

7. Appareil selon au moins une des revendications 1 à 5, **caractérisé en ce que** le capteur (10) délivre un signal de mesure soumis à un décalage de capteur et **en ce que** le décalage de capteur peut être décalé vers des fréquences plus hautes, au moyen d'un mélangeur de fréquences analogique-carré (12a) supplémentaire, autour de la fréquence de décalage f_{D} et peut être amené sur le trajet de signal entre le capteur (10) et le convertisseur numérique-analogique (16) avant, après ou dans l'amplificateur (14) pour produire une différence avec le signal concerné avant, après ou dans l'amplificateur (14) .

8. Appareil selon la revendication 7, **caractérisé en ce que** l'amplificateur (14) comporte un premier étage amplificateur pour préamplifier le signal de mesure analogique et un second étage amplificateur, dans lequel le signal analogique amplifié présent après le second étage amplificateur peut être conduit au convertisseur numérique-analogique (16), et **en ce que** le décalage de capteur du second étage amplificateur décalé à la fréquence de décalage f_{D} peut être amené à produire une différence avec le signal de sortie du premier étage amplificateur.
